(19) Europäisches Patentamt / European Patent Office / Office européen des brevets

(11) **EP 1 981 171 B1**

(12) **EUROPEAN PATENT SPECIFICATION**

(45) Date of publication and mention
of the grant of the patent:
**04.07.2012 Bulletin 2012/27**

(51) Int Cl.:
***H03M 13/09*** *(2006.01)*

(21) Application number: **07290456.8**

(22) Date of filing: **13.04.2007**

(54) **Apparatus and method for the parallel generation of cyclic redundancy check (CRC) codes**

Vorrichtung und Verfahren zur parallelen Generierung von Cyclic Redundancy Check (CRC) Kodes

Dispositif et méthode pour la génération en parallèle des codes à contrôle de redondance cyclique (CRC)

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**15.10.2008 Bulletin 2008/42**

(73) Proprietor: **Alcatel Lucent
75007 Paris (FR)**

(72) Inventors:
• **Costantini, Carlo
22064 Casatenovo (Lecco) (IT)**
• **Crescentini, Roberta
23883 Brivio (Lecco) (IT)**
• **Bergamin, Stefania
20040 Cavenago di Brianza (Milano) (IT)**

(74) Representative: **Wetzel, Emmanuelle et al
Alcatel-Lucent Deutschland AG
Intellectual Property & Corporate Standards
Lorenzstrasse 10
70435 Stuttgart (DE)**

(56) References cited:
**US-A- 5 671 238      US-A1- 2003 120 992
US-B1- 6 519 737**

• **JING-SHIUN LIN ET AL: "High-speed CRC design for 10 Gbps applications" PROC. 2006 IEEE INTERNATIONAL SYMPOSIUM ON CIRCUITS AND SYSTEMS, 21 May 2006 (2006-05-21), - 24 May 2006 (2006-05-24) pages 3177-3181, XP002437966 IEEE PISCATAWAY, NJ, USA ISBN: 0-7803-9389-9**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Technical field**

The present invention generally relates to the field of telecommunication networks. More particularly, the present invention relates to a device and a method for calculating a check sequence of a data sequence in a telecommunication network, in particular a packet-switched telecommunication network.

**Background art**

It is known that in a packet-switched telecommunication network (such as for instance an Internet network, an Ethernet network, etc.), data are transmitted in the form of packets. Each packet typically has a header and a payload. The header typically comprises a source address, identifying a source node which originated the packet, and a destination address, identifying an addressee node which has to receive the packet. The payload comprises a sequence of data to be transmitted.

Upon reception of a packet, the addressee node is typically responsible of checking whether the packet has been correctly received, i.e. whether the data sequence comprised in the received packet actually corresponds to the original data sequence comprised in the packet transmitted by the source node. If the packet has been correctly received, the addressee node performs further processing of the packet. On the contrary, if the packet has not been correctly received, the packet is discarded.

For checking reception correctness, it is known to insert in each packet a respective check sequence, which allows the addressee node to check whether the data sequence comprised in a received packet corresponds to the original data sequence.

More particularly, according to the known "Cyclic Redundancy Check" technique (or, briefly, CRC technique), a data sequence of m bits $(A_m, ..., A_2, A_1)$ to be transmitted in a single packet is associated to a polynomial $M(x)$ equal to:

$$M(x)=x^m+A_m x^{m-1}+ ... + A_2 x+ A_1. \qquad [1]$$

According to the CRC technique, the source node of the data sequence performs on $M(x)$ the following operation:

$$M(x) \cdot x^n = Q(x)\,K(x)+R(x), \qquad [2]$$

$K(x)$ being a predefined polynomial, which is typically termed "key polynomial", having degree n, wherein n is an integer equal to or higher than 2. $Q(x)$ is the quotient polynomial obtained by dividing $M(x) \cdot x^n$ by $K(x)$, while $R(x)$ is the residual polynomial obtained by dividing $M(x) \cdot x^n$ by $K(x)$. Also $R(x)$ has degree n. Typically, the key polynomial has n=16 or n=32. For instance, the most commonly used polynomial having degree n=16 is: $K_{16}(x) = x^{16}+x^{15}+x^2+x^2+1$, while the most commonly used polynomial having degree n=32 is: $K_{32}(x) = x^{32} + x^{26} + x^{23} + x^{22} + x^{16} + x^{12} + x^{11}+ x^{10}+ x^8 + x^7 + x^5 + x^4 + x^2 + x + 1$.

According to the CRC technique, the coefficients $(R_n, ..., R_2, R_1)$ of the residual polynomial $R(x)$ are the check sequence of the data sequence $(A_m, ..., A_2, A_1)$.

Then, the source node concatenates the data sequence $(A_m, ..., A_2, A_1)$ and the check sequence $(R_n, ..., R_2, R_1)$, thus forming a so-called "codeword" $(A_m, ..., A_2, A_1, R_n, ..., R_2, R_1)$, which is inserted in the packet and transmitted to the addressee node.

Upon reception, the addressee node extracts from the received packet the received codeword and it divides it by $K(x)$. If the remainder of such a division is zero, the addressee node determines that the received data sequence actually corresponds to the original data sequence. Otherwise, the addressee node determines that the received data sequence contains at least one error.

Typically, the source node performs the above operation [2] by means of a shift register having size equal to the degree n. More particularly, the source node makes the content of the shift register evolve periodically, with a given evolution period. Each evolution at each evolution period typically comprises a right-shift of the shift register content, the insertion of a bit of the original data sequence in the most significant position of the shift register, and a XOR operation between the shift register content and the key polynomial. Evolution of the shift register content is performed m times, i.e. it is performed until each bit of the original data sequence has been inserted in the shift register. Therefore, the evolution period of the shift register substantially corresponds to the bit period.

However, when the bit period is very small (for instance, in telecommunication networks having bit-rates of 1 Gb/s or more), the source node calculates the check sequence by using a parallel device, i.e. a device which is adapted to process in parallel k bits of the original data sequence at each evolution period. This allows to increase the evolution period by a factor k. In the following description and in the claims, the expression "processing parallel degree" will designate the number k of bits belonging to the original data sequence, which the parallel device of the source node is able to process in parallel.

The operation performed by the parallel device at each evolution period may be described by the following matrix equation:

$$r(i)=I(i) \ M1+ r(i-1) \ M2, \hspace{4cm} [3]$$

wherein I(i) is an array comprising k bits entering the parallel device during the i-th evolution period, r(i-1) is the array resulting from equation [3] when executed during the previous evolution period (i-1)-th, while M1 and M2 are two matrixes. The operation described by equation [3] is performed at every evolution period, until all the bits of the original data sequence has been inserted in the parallel device. In other words, the parallel device evolves m/k times. Therefore, the check sequence of the original data sequence is the result of equation [3] when performed during the evolution period m/k.

For instance, for a telecommunication network with bit-rate of few Gb/s (e.g. 2.5 Gb/s), k is typically equal to 8, i.e. 1 byte, as disclosed in "Parallel Cyclic Redundancy Check (CRC) for HOTLink™" published in March 1999 by Cypress Semiconductor Corporation, which discloses algorithms for parallel calculation of CRC-16 and CRC-32.

US 2003/0120992 discloses a CRC checking 'N-bit at a time' of data frames of lengths not necessarily in a multiple of the N-bit. While receiving the data frame, the data frame length is extracted from the protocol header and a misalignment is computed versus the'N-bit at a time' value. Simultaneously, CRC is computed on each received N-bit of the data frame and an FCS register is updated. At each cycle, a checking is performed to know whether the data frame length has been extracted from the protocol header. While the data frame length is not yet known and more bits are left to process, the data frame is continued to be received and computed 'N-bit at a time'. When the data frame length is known and no more bits are to be processed, the current value of the FCS register is compared to a pre-stored vector corresponding to the misalignment. If a match occurs, checking of the data frame passes and the data frame is accepted. If a match does not occur, checking of the data frame fails and the data frame may be rejected.

US 6,519,737 discloses a method for computing cyclic redundancy code (CRC) for use in a communication data stream M bits at a time for an input sequence u(n) whose length is not a multiple of M. The method includes (i) representing a frame of data to be protected as the input sequence; (ii) determining a cyclic redundancy code (CRC) for the input sequence M bits at a time from a state vector, until a last block of the input sequence is reached; (iii) if the last block of the input sequence is full, then determining the CRC to be a completed CRC; and (iv) if the last block of the input sequence is not full, then performing three functions.

The paper "High-speed CRC design for 10 Gbps applications" of Jing-Shiun Lin et al., Proc. 2006 IEEE International Symposium on Circuits and Systems, 21-24 May 2006, pages 3177-3181, XP002437966, discloses how to design high-speed CRC circuitry for 10 Gbps applications.

## Summary of the invention

The Applicant has noticed that the above known technique for calculating a check sequence of a given original data sequence has some drawbacks.

Indeed, when k is equal to 8, i.e. 1 byte, the above known technique may be applied to every type of packet, since every type of packet, irrespective of its format (e.g. IP packet, Ethernet packet, ATM packet, etc.) is adapted to tra nsport a data sequence having a integer number of bytes, i.e. having a number m of bits equal to an integer multiple of the parallelism degree k=8.

However, in telecommunication systems with bit-rates as high as tens of Gb/s (e.g. 10 or 40 Gb/s), k must be higher than 8, since the maximum acceptable evolution period for the parallel device of the source node is of few hundreds of MHz. In these cases, the above known technique works in a correct way only if m, i.e. the number of bits comprised in the original data sequence, is an integer multiple of the parallelism degree k. Indeed, when m is not an integer multiple of k, during the last evolution period (i.e. during the evolution period int(m/k)+1) a number of bits lower than k are inserted in the parallel device, and therefore the operation described by the equation [3] can not be performed in a correct way.

Therefore, the Applicant has faced the problem of providing a device and method for calculating a check sequence of a data sequence which overcomes the aforesaid problem, i.e. which can be applied to every packet independently of the fact that the number of bits comprised in the data sequence to be inserted in the packet is a multiple integer of the parallelism degree of the parallel device performing the calculation.

According to a first aspect, the present invention provides a device for calculating a check sequence of a data sequence to be transmitted in a packet-switched network, the device comprises: an extended sequence generation module configured to receive the data sequence and to generate an extended sequence having a first number of bits, the extended sequence comprising the data sequence in a least significant portion thereof, and the extended sequence comprising predefined bits in a remaining most significant portion thereof, the first number being an integer multiple of a second number; a frame check sequence module configured to receive the extended sequence and to calculate an extended check sequence of the extended sequence by using the second number as calculation parallelism degree, wherein the most significant portion comprising the predefined bits is input into the frame check sequence module during a last evolution period; and a compensation module configured to receive the extended check sequence and to apply to the extended check sequence a compensation for compensating a contribution of the predefined bits, thus obtaining the check sequence, wherein the compensation module comprises at least a compensation circuit which is configured to compensate contribution of a predefined number of the predefined bits. The device is characterized in that the compensation module comprises a feedback loop, the compensation circuit being part of the feedback loop, and the compensation module comprises a load block configured to extract the check sequence from the feedback loop after a further predefined number of evolution periods of the feedback loop.

The compensating circuit may comprise a matrix which is related to the inverse of a matrix comprised in the frame check sequence module.

According to a second aspect, the present invention provides a device for calculating a check sequence of a data sequence to be transmitted in a packet-switched network, the device comprises: an extended sequence generation module configured to receive the data sequence and to generate an extended sequence having a first number of bits, the extended sequence comprising the data sequence in a least significant portion thereof, and the extended sequence comprising predefined bits in a remaining most significant portion thereof, the first number being an integer multiple of a second number; a frame check sequence module configured to receive the extended sequence and to calculate an extended check sequence of the extended sequence by using the second number as calculation parallelism degree, wherein the most significant portion comprising the predefined bits is input into the frame check sequence module during a last evolution period; and a compensation module configured to receive the extended check sequence and to apply to the extended check sequence a compensation for compensating a contribution of the predefined bits, thus obtaining the check sequence. The device is characterized in that the compensation module comprises at least a first compensating circuit and a second compensating circuit, the first compensating circuit being configured to compensate contribution of a first predefined number of the predefined bits and the second compensating circuit being configured to compensate contribution of a second predefined number of the predefined bits, the first predefined number being equal to eight and the second predefined number being equal to sixteen, the second compensating circuit being serially connected to the first compensating circuit.

According to a third aspect, the present invention provides a network element of a packet-switched network, wherein the network element comprises a device for calculating a check sequence of a data sequence to be transmitted in the packet-switched network, and wherein the device is as set forth above.

According to a fourth aspect, the present invention provides a computer program comprising computer-executable instructions for performing, when said computer program is run on a computer, a method for calculating a check sequence of a data sequence to be transmitted in a packet-switched network, the method comprising: receiving the data sequence and generating an extended sequence having a first number of bits, the extended sequence comprising the data sequence in a least significant portion thereof, and the extended sequence comprising predefined bits in a remaining most significant portion thereof, the first number being an integer multiple of a second number; calculating an extended check sequence of the extended sequence by using the second number as calculation parallelism degree, wherein the most significant portion comprising the predefined bits is input during a last evolution period; and applying to the extended check sequence a compensation for compensating a contribution of the predefined bits, thus obtaining the check sequence. The computer program is characterized in that compensating comprises compensating contribution of a first predefined number of the predefined bits and serially compensating contribution of a second predefined number of the predefined bits, the first predefined number being equal to eight and the second predefined number being equal to sixteen.

## Brief description of the drawings

The present invention will become more clear by reading the following detailed description, given by way of example and not of limitation, to be read by referring to the accompanying drawings, wherein:

- Figure 1 schematically shows a device for calculating a check sequence of a given data sequence, according to an embodiment of the present invention;
- Figures 2a and 2b schematically show a data sequence and an extended sequence, according to embodiments of the present invention;

- Figure 3 shows in further detail the structure of the compensation module shown in Figure 1, according to a first embodiment of the present invention; and
- Figure 4 shows in further detail the structure of the compensation module shown in Figure 1, according to a second embodiment of the present invention.

## Detailed description of preferred embodiments of the invention

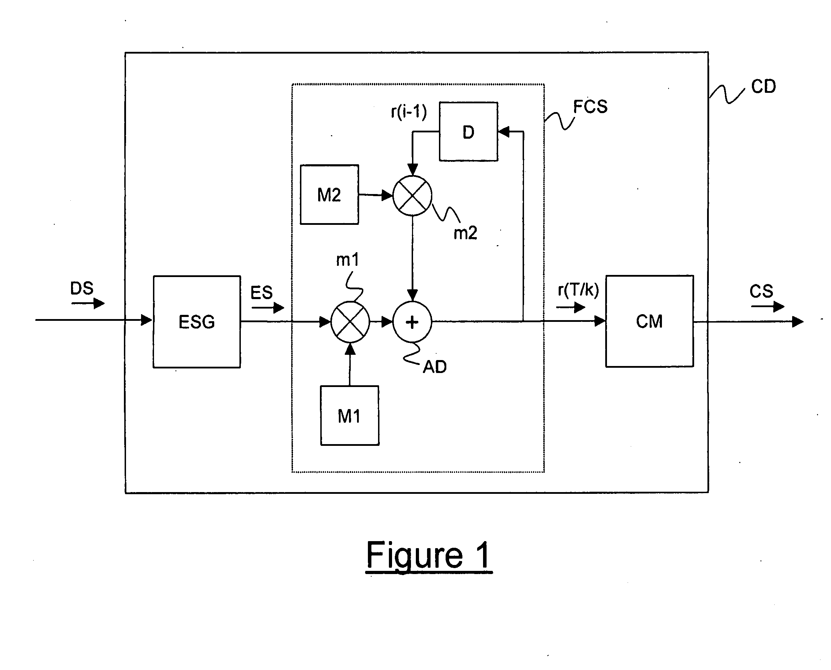

Figure 1 schematically shows a device CD for calculating a check sequence CS of a data sequence DS, according to an embodiment of the present invention.

The device CD comprises the cascade of an extended sequence generation module ESG, a frame check sequence module FSC and a compensation module CM.

The module FCS is a parallel device of the type described in the introduction, which is capable of calculating the check sequence of a data sequence according to the above described known CRC technique. The structure of the module FCS shown in Figure 1 is merely exemplary, since the module FCS may be implemented according to any known technique. The module FCS comprises an adder AD having two inputs and one output, a first multiplier m1 and a second multiplier m2. Both m1 and m2 have their outputs connected to a respective input of the adder AD. Further, the module FCS comprises a delay block D, having an input connected to the output of the adder AD.

Further, the module FCS comprises two matrixes M1 and M2. The first multiplier m1 has a first input corresponding to the input of the module FSC and a second input connected to the matrix M1. The second multiplier m2 has a first input connected to the output of the delay block D and a second input connected to the matrix M2. In other words, the delay block D and the second multiplier m2 form a feedback loop.

The matrix M1 has size kxn, k being the processing parallelism degree of the module FCS, and n being the length of the check sequence calculated by the module FCS. The matrix M2 has size nxn. The coefficients of the matrixes M1, M2 are predefined, and they depend, inter alia, on the coefficients of the key polynomial K(x) according to equations which are not described, since they are not relevant to the present description.

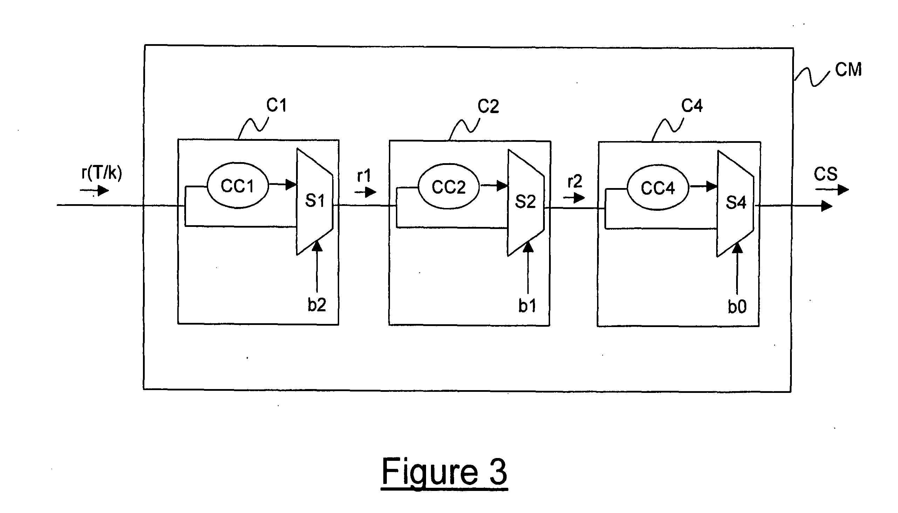

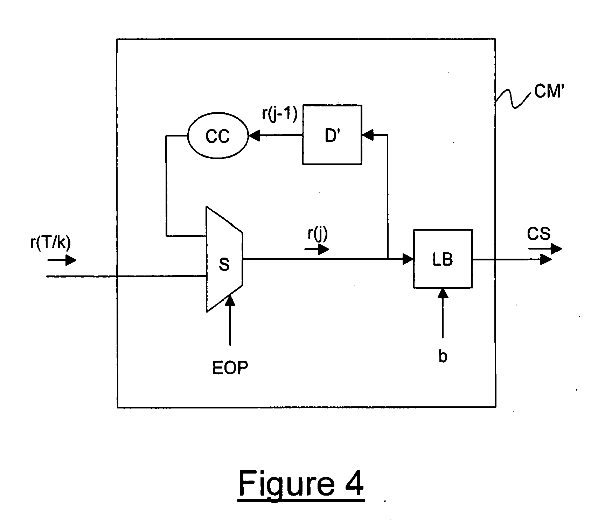

The output of the adder AD (corresponding to the output of the module FCS) is connected to the compensation module CM. The structure of the compensation module CM according to a first and a second embodiment of the present invention will be described in further detail herein after by referring to Figures 3 and 4, respectively.

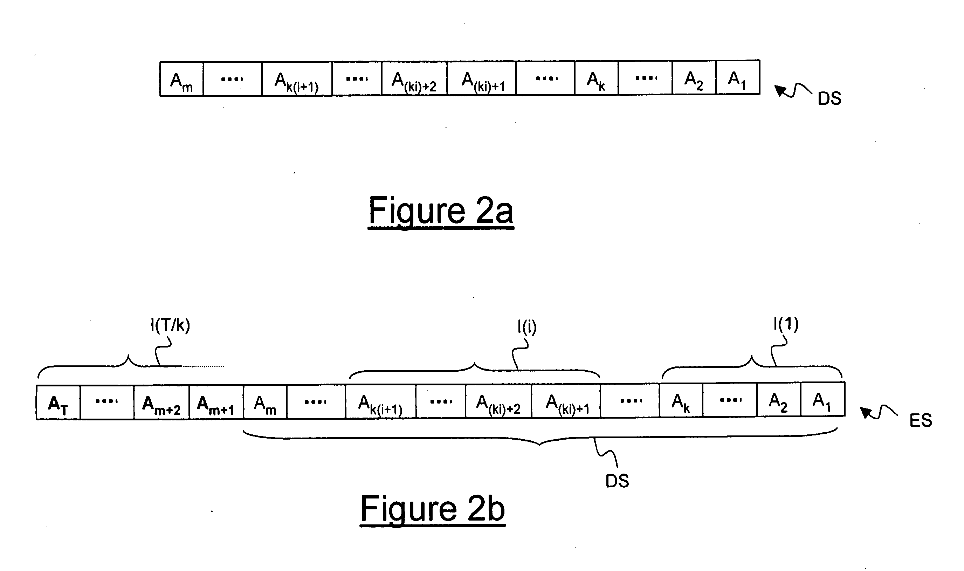

Now, by referring to Figure 1 and also to Figures 2a and 2b, the operation of the device CD will be described in detail.

It is assumed that the device CD is used to calculate the check sequence CS of a data sequence DS, which is shown in Figure 2a. The data sequence DS comprises m bits $A_m$, ..., $A_2$, $A_1$. For instance, it is assumed that m is equal to 648, i.e. 81 bytes. Further, it is assumed that the processing parallelism degree k of the module FCS is equal to 64, i.e. 8 bytes. Therefore, by assuming that the data sequence DS has a bit-rate of 10 Gb/s, the evolution frequency (i.e. the inverse of the evolution period) of the module FCS is 10 GHz / k = 10 GHz / 64 = 156,25 MHz.

According to embodiments of the present invention, when the device CD has to calculate the check sequence of the data sequence DS, the module ESG receives the data sequence DS and it generates a new sequence, which in the following description and in the claims will be termed "extended sequence". The extended sequence of the data sequence DS is indicated in Figures 1 and 2b as ES. Advantageously, the extended sequence ES comprises T bits, T being an integer multiple of k and being higher than m. Preferably, T is the smallest of the integer multiples of k which are higher than m. For instance, when m is equal to 648 (i.e. 81 bytes) and k is equal to 64 (i.e. 8 bytes), T is preferably equal to 704 (i.e. 88 bytes).

Advantageously, the extended sequence ES comprises, in its m least significant positions, the m bits $A_m$, ..., $A_2$, $A_1$ of the data sequence DS. Further, in its remaining (T-m) most significant positions, the extended sequence ES comprises (T-m) additional bits $A_T$, ..., $A_{m+2}$, $A_{m+1}$ having a predefined value. Preferably, such a predefined value is equal to 0.

The extended sequence ES is then provided at the input of the module FCS. In particular, during each evolution period of the module FCS, k consecutive bits of the extended sequence ES are inserted in parallel into the module FCS. Therefore, during the first evolution period, the input I(1) of the module FCS comprises the first k bits $A_k$, ..., $A_2$, $A_1$ of the extended sequence ES. Similarly, during the i-th evolution period, the input I(i) of the module FCS comprises the i-th k bits $A_{k(i+1)}$, ..., $A_{(ki)+2}$, $A_{(ki)+1}$ of the extended sequence ES. Finally, during the last evolution period (i.e. (T/k)-th), the input I(T/k) of the module FCS comprises the last k bits $A_T$, ..., $A_{m+2}$, $A_{m+1}$, $A_m$, ... of the extended sequence ES.

During the i-th evolution period, the module FCS therefore receives the input I(i). In particular, the input I(i) is received by the first multiplier m1, which multiplies it by the matrix M1. Further, the second multiplier m2 receives from the delay block D the sequence r(i-1) output by the adder AD during the previous evolution period (i-1)-th, and it multiplies it by the matrix M2. Therefore, the sequence r(i) output by the adder AD during the i-th evolution period is r(i)=I(i)M1 + r(i-1) M2, corresponding to the above equation [3].

Therefore, at the end of the (T-k)-th evolution period, the adder AD (i.e. the block FCS) outputs a sequence r

5

(T/k) which corresponds to the check sequence of the extended sequence ES. In the following description and in the claims, the check sequence r(T/k) of the extended sequence ES will be termed "extended check sequence".

The Applicant has noticed that, for obtaining the check sequence CS of the data sequence DS from the extended check sequence r(T/k) calculated by the module FCS, the contributions of the (T-m) additional bits $A_T$, ..., $A_{m+2}$, $A_{m+1}$ have to be compensated. To this purpose, the extended check sequence r(T/k) has to undergo a number of compensation operations, which are performed by the compensation module CM.

Figure 3 shows the structure of the compensation module CM according to a first embodiment of the present invention.

According to this first embodiment, the compensation module CM comprises three cascaded compensation blocks C1, C2, C4. The presence of three cascaded compensation blocks is merely exemplary. Indeed, the compensation module CM preferably comprises a number of cascaded compensation blocks equal to h, h being an integer dependent on the processing parallelism degree k of the module FCS and other factors, which will be described in further detail herein after.

Each compensation block C1, C2, C4 comprises a respective two-input switch S1, S2, S4 which is adapted to be controlled by a respective control signal b2, b1, b0. Further, each compensation block C1, C2, C4 comprises, on one of the input of its respective switch S1, S2, S4, a compensating circuit CC1, CC2, CC4, whose function will be described in further detail herein after. The output of the compensation block C4 corresponds to the output of the device CD.

According to this first embodiment, each compensation block is adapted to compensate the contributions of one or more of the additional bits $A_T$, ..., $A_{m+2}$, $A_{m+1}$. For example, if m is equal.to 648 (i.e. 81 bytes) and k is equal to 64 (i.e. 8 bytes), T is preferably equal to 704 (i.e. 88 bytes). Therefore, for obtaining the check sequence CS of the data sequence DS, contributions of T-m= 56 additional bits (i.e. 7 bytes) have to be compensated.

In the compensation module CM shown in Figure 3, it is assumed that the first compensation block C1 is adapted to compensate the contributions of 8 additional bits (i.e. 1 byte), while the second compensation block C2 is adapted to compensate the contributions of 16 additional bits (i.e. 2 bytes), and the third compensation block C4 is adapted to compensate the contributions of 32 additional bits (i.e. 4 bytes). Therefore, the three cascaded compensation blocks C1, C2, C4 advantageously allow to compensate the contributions of any integer multiple of 8 bits comprised between 8 bits (i.e. 1 byte) and 56 bits (i.e. 7 bytes).

From the implementation point of view, the compensating circuit CC1 comprised in the first compensation block C1 is a matrix fulfilling the following equation:

$$CC1^8 = M2^{-1}.$$

Similarly, the compensating circuit CC2 comprised in the second compensation block C2 is a matrix fulfilling the following equation:

$$CC2^4 = M2^{-1}.$$

Similarly, the compensating circuit CC4 comprised in the third compensation block C4 is a matrix fulfilling the following equation:

$$CC1 = M2^{-1}.$$

More particularly, the first compensation block C1 receives the extended check sequence r(T/k) output by the module FCS at the evolution period (T/k)-th. The extended check sequence r(T/k) is sent to both inputs of the switch S1. On the first input, the extended check sequence r(T/k) is processed by the compensating circuit CC1, which compensates the contribution of 1 byte, while on the other input the extended check sequence r(T/k) does not undergo any processing. When the first control signal b2 is equal to a first value (e.g. 1), the sequence r1 output by the switch S1 is the extended check sequence r(T/k) after processing by the compensating circuit CC1. Conversely, when the first control signal b2 is equal to a second value (e.g. 0), the sequence r1 output by the switch S1 is the extended check sequence r(T/k).

Then, the sequence r1 output by the first compensation block C1 is forwarded to the second compensation block C2. In particular, the sequence r1 is sent to both inputs of the switch S2. On the first input, the sequence r1 is processed by the compensating circuit CC2, which compensates the contribution of 2 bytes, while on the other input the sequence r1 does not undergo any processing. When the second control signal b1 is equal to a first value (e.g. 1), the sequence r2 output by the switch S2 is the sequence r1 after processing by the compensating circuit CC2. Conversely, when the second control signal b1 is equal to a second value (e.g. 0), the sequence r2 output by the switch S2 is the sequence r1.

Finally, the sequence r2 output by the second compensation block C2 is forwarded to the third compensation block C4. In particular, the sequence r2 is sent to both inputs of the switch S4. On the first input, the sequence r2 is processed by the compensating circuit CC4, which compensates the contribution of 4 bytes, while on the other input the sequence r2 does not undergo any processing. When the third control signal b0 is equal to a first value (e.g. 1), the sequence CS output by the switch S4 is the sequence r2 after processing by the compensating circuit CC4. Conversely, when the third control signal b0 is equal to a second value (e.g. 0), the sequence CS output by the switch S4 is the sequence r2.

In any case, the sequence CS output by the third compensation block C4 (and therefore, by the device CD) is the check sequence CS of the data sequence DS of Figure 2a.

Preferably, the control signals b2, b1, b0 are the three digits of the number T-m expressed in bytes and formatted according to the binary coding. In the above cited example wherein T-m is equal to 56 (i.e. 7 bytes, i.e. "111" in binary coding), the control signals preferably are: b2=1, b1=1 and b0=1. Therefore, all the three compensation blocks C1, C2, C4 actually perform respective compensations, and therefore an overall compensation of contributions of 7 bytes is performed on the extended check sequence r(T/k).

For instance, if the number m of bits comprised in the data sequence DS is 664 (i.e. 83 bytes), with k equal to 64 T would preferably be again 704 (i.e. 88 bytes). Therefore, T-m would be equal to 40 (i.e. to 5 bytes). The binary coding of 5 is "101", therefore the control signals preferably are: b2=1, b1=0 and b0=1. Therefore, only the first and third compensation blocks C1 and C4 actually compensate contributions of 1 byte and 4 bytes respectively, while the second compensation blocks C2 does not perform any compensation.

Therefore, the above cited number h of compensation blocks to be cascaded in the compensation module CM depends both of the processing parallelism degree k of the module FCS and of the number of additional bits whose contributions each compensation block is able to compensate. Indeed, if the parallelism degree k is equal to 64 (i.e. 8 bytes), entailing that the contributions of at most 57 additional bits (i.e. 7 bytes) could have to be compensated according to the number m of bits of the original data sequence, an embodiment of the compensation module CM not shown in the drawing may comprise seven cascaded compensation blocks in place of the three compensation blocks C1, C2, C4 shown in Figure 1, each compensation block being adapted to compensate contributions of 8 additional bits (i.e. 1 byte).

Therefore, advantageously, the present invention allows to calculate the check sequence of a given data sequence, independently of the ratio between the number of bits comprised in the data sequence and the processing parallelism degree of the module FCS. Indeed, generation of the extended data sequence having a length equal to an integer multiple of the processing parallelism degree k, application of equation [3] to the extended sequence and subsequent compensation of contributions of additional bits advantageously allows to calculate the check sequence of any data sequence, independently of its size. This advantageously allows to apply the above calculation to any kind of packet (Ethernet, IP, MPLS, etc.), independently of its size. Further, this advantageously allows to choose the processing parallelism degree k of the module FCS as a function of the bit-rate (for, instance, k may be chosen equal to 64 bits or more, in case of packet-switched networks with bit-rates of 10 Gb/s or more), without the constraint of choosing k so that the ratio between the number m of bits and the parallelism degree k is an integer number. Therefore, a given value of k may be employed for different types of packet-switched network, as well as for a packet-switched network wherein the packet size is variable.

In the compensation module CM according to the first embodiment of the present invention, compensation of additional bit contributions is performed by compensation blocks which are serially connected one another. This advantageously allows to perform compensation in few evolution periods (in particular, three evolution period), since each compensation block is adapted to perform compensation of contributions of a plurality of additional bits in a single evolution period.

Figure 4 schematically shows a compensation module CM' according to a second embodiment of the present invention.

The compensation module CM' of Figure 4 comprises a further delay block D', a compensating circuit CC, a switch S controlled by an end-of-packet signal EOP and a load block LB controlled by a control signal b.

The output of the load block LB corresponds to the output of the device CD. The switch S has a first input corresponding to the input of the compensation module CM' and a second input connected to the output of the compensating circuit CC. Further, the switch S has an output connected to the input of the load block LB. Further, the output of the switch S is connected to the input of the further delay block D'. The load block LB has an output which corresponds to the output of the compensation module CM' (and therefore of the device CD). Besides, the output of the further delay block D' is connected to the input of the compensating circuit CC. Accordingly, the switch S, the further delay block D' and the compensating circuit CC form a feedback loop.

In the following, by referring to Figure 4 and also to Figures 2a and 2b, the operation of the compensation module CM' according to the second embodiment of the present invention will be explained in detail.

Also in this second embodiment, it is assumed that the device CD is employed for calculating the check sequence CS of the data sequence DS shown in Figure 2a, which data sequence DS comprises m bits. Again, it is assumed that m is equal to 648 (i.e. 81 bytes), and that the parallelism degree k of the module FCS is equal to 64 (i.e. 8 bytes).

Also according to this second embodiment, it is assumed that the extended sequence generation module ESG generates the extended sequence ES which is shown in Figure 2b. The extended sequence ES still has T bits, where T is chosen according to the above cited criteria. The features of the extended sequence ES have been described above by referring to Figure 2b, therefore a detailed description will not be repeated.

Then, the extended sequence ES is inserted in the module FCS. As already explained by referring to Figure 1, at the end of the (T/k)-th evolution period, the module FCS outputs a sequence r(T/k) which corresponds to the check sequence of the extended sequence ES.

According to the second embodiment of the present invention, at the end of the (T/k)-th evolution period, the end-of-packet signal EOP controlling the switch S of the compensation module CM' changes value, and it induces the switch S to forward the extended check sequence r(T/k) to the feedback loop formed by the switch S itself, the further delay block D' and the compensating circuit CC.

Accordingly, during each evolution period the further delay block D' receives a sequence r(j) (which, during the evolution period ((T/k)+1)-th, corresponds to the extended check sequence r(T/k)), it delays r(j) thus obtaining a delayed sequence r(j-1) and it forwards it to the compensating circuit CC, which processes it. According to this second embodiment, during each evolution period the compensating circuit CC compensates contributions of the predefined number p of additional bits $A_T$, ..., $A_{m+2}$, $A_{m+1}$.

For instance, if m is equal to 648 (i.e. 81 bytes) and k is equal to 64 (i.e. 8 bytes), T is preferably equal to 704 (i.e. 88 bytes), T-m is equal to 56 (i.e. 7 bytes). By assuming p equal to 8 bits (i.e. 1 byte), it follows that (T-m)/p=7 evolution periods are required for compensating contributions of all additional bits. From the implementation point of view, in case the compensation circuit is configured for compensating contributions of 8 bits, the compensating circuit CC is a matrix fulfilling the following equation:

$$CC1^8 = M2^{-1}.$$

Then, after (T-m)/p evolution periods the control signal b changes value thus activating the load block LB, which then loads the sequence r(j) present in the feedback loop during such an evolution period, which sequence r(j) corresponds to the check sequence CS. The check sequence CS is then output by the load block LB, i.e. by the device CD.

Therefore, according to this second embodiment, the compensation module CM' has a simpler structure in comparison to the first embodiment shown in Figure 3, since it comprises a single compensation circuit CC. It has to be noticed that the overall calculation time is increased in comparison to the first embodiment, since the overall number of evolution periods required for performing compensation is equal to the number of additional bits T-m divided by the predefined number p of bits whose contributions the compensating circuit CC is adapted to compensate.

In any case, advantageously, also this second embodiment of the present invention allows to calculate the check sequence of a data sequence independently of the ratio between the data sequence size and the calculation parallelism degree of the module FCS.

**Claims**

1.   A device (CD) for calculating a check sequence (CS) of a data sequence (DS) to be transmitted in a packet-switched network, the device (CD) comprising:

   a) an extended sequence generation module (ESG) configured to receive said data sequence (DS) and to generate an extended sequence (ES) having a first number of bits, said extended sequence (ES) comprising said data sequence (DS) in a least significant portion thereof, and said extended sequence (ES) comprising predefined bits (AT, ..., $A_{m+2}$, $A_{m+1}$) in a remaining most significant portion thereof, said first number being an integer multiple of a second number k;
   b) a frame check sequence module (FCS) configured to receive said extended sequence (ES) and to calculate an extended check sequence (r(T/k)) of said extended sequence (ES) by using said second number k as calculation parallelism degree, wherein said most significant portion comprising said predefined bits ($A_T$, ..., $A_{m+2}$, $A_{m+1}$) is input into said frame check sequence module (FCS) during a last evolution period; and
   c) a compensation module (CM') configured to receive said extended check sequence (r(T/k)) and to apply to said extended check sequence (r(T/k)) a compensation for compensating a contribution of said predefined bits

$(A_T, ..., A_{m+2}, A_{m+1})$, thus obtaining said check sequence (CS), said compensation module (CM') comprises at least a compensating circuit (CC) which is configured to compensate contribution of a predefined number of said predefined bits $(A_T, ..., A_{m+2}, A_{m+1})$,

**characterized in that** said compensation module (CM') further comprises a feedback loop, said compensating circuit (CC) being part of said feedback loop, and said compensation module (CM') further comprising a load block (LB) configured to extract said check sequence (CS) from said feedback loop after a further predefined number of evolution periods of said feedback loop.

2. The device (CD) according to claim 1, wherein said compensating circuit (CC) comprises a matrix which is related to the inverse of a matrix (M2) comprised in said frame check sequence module (FCS).

3. A device (CD) for calculating a check sequence (CS) of a data sequence (DS) to be transmitted in a packet-switched network, the device (CD) comprising:

a) an extended sequence generation module (ESG) configured to receive said data sequence (DS) and to generate an extended sequence (ES) having a first number of bits, said extended sequence (ES) comprising said data sequence (DS) in a least significant portion thereof, and said extended sequence (ES) comprising predefined bits $(A_T, ..., A_{m+2}, A_{m+1})$ in a remaining most significant portion thereof, said first number being an integer multiple of a second number k;
b) a frame check sequence module (FCS) configured to receive said extended sequence (ES) and to calculate an extended check sequence (r(T/k)) of said extended sequence (ES) by using said second number k as calculation parallelism degree, wherein said most significant portion comprising said predefined bits $(A_T, ..., A_{m+2}, A_{m+1})$ is input into said frame check sequence module (FCS) during a last evolution period; and
c) a compensation module (CM) configured to receive said extended check sequence (r(T/k)) and to apply to said extended check sequence (r(T/k)) a compensation for compensating a contribution of said predefined bits $(A_T, ..., A_{m+2}, A_{m+1})$, thus obtaining said check sequence (CS),

**characterized in that** said compensation module (CM) comprises at least a first compensating circuit (CC1) and a second compensating circuit (CC2), the first compensating circuit (CC1) being configured to compensate contribution of a first predefined number of said predefined bits $(A_T, ..., A_{m+2}, A_{m+1})$ and the second compensating circuit (CC2) being configured to compensate contribution of a second predefined number of said predefined bits $(A_T, ..., A_{m+2}, A_{m+1})$, said first predefined number being equal to eight and said second predefined number being equal to sixteen, said second compensating circuit (CC2) being serially connected to said first compensating circuit (CC1).

4. A network element of a packet-switched network, said network element comprising a device (CD) for calculating a check sequence (CS) of a data sequence (DS) to be transmitted in said packet-switched network, said device (CD) being according to any of claims 1 to 3.

5. A computer program comprising computer-executable instructions for performing, when said computer program is run on a computer, a method for calculating, a check sequence (CS) of a data sequence (DS) to be transmitted in a packet-switched network, said method comprising:

a) receiving said data sequence (DS) and generating an extended sequence (ES) having a first number of bits, said extended sequence (ES) comprising said data sequence (DS) in a least significant portion thereof, and said extended sequence (ES) comprising predefined bits $(A_T, ..., A_{m+2}, A_{m+1})$ in a remaining most significant portion thereof, said first number being an integer multiple of a second number k;
b) calculating an extended check sequence (r(T/k)) of said extended sequence (ES) by using said second number k as calculation parallelism degree, wherein said most significant portion comprising said predefined bits $(A_T, ..., A_{m+2}, A_{m+1})$ is input during a last evolution period; and
c) applying to said extended check sequence (r(T/k)) a compensation for compensating a contribution of said predefined bits $(A_T, ..., A_{m+2}, A_{m+1})$, thus obtaining said check sequence (CS),

said computer program being **characterized in that** said compensating comprises compensating contribution of a first predefined number of said predefined bits $(A_T, ..., A_{m+2}, A_{m+1})$ and serially compensating contribution of a second predefined number of said predefined bits $(A_T, ..., A_{m+2}, A_{m+1})$, said first predefined number being equal to eight and said second predefined number being equal to sixteen.

## EP 1 981 171 B1

**Patentansprüche**

1.  Vorrichtung (CD) zur Berechnung einer Prüfsequenz (CS) einer in einem paketvermittelten Netzwerk zu übertragenden Datensequenz (DS), wobei die Vorrichtung (CD) umfasst:

    a) ein Modul zur Erzeugung einer erweiterten Sequenz (ESG), welches dafür konfiguriert ist, die besagte Datensequenz (DS) zu empfangen und eine erweiterte Sequenz (ES) mit einer ersten Anzahl von Bits zu erzeugen, wobei die besagte erweiterte Sequenz (ES) die besagte Datensequenz (DS) in einem niedrigstwertigen Teil davon umfasst, und wobei die besagte erweiterte Sequenz (ES) vordefinierte Bits ($A_T$, ..., $A_{m+2}$, $A_{m+1}$) in einem restlichen höchstwertigen Teil davon umfasst, wobei die besagte erste Anzahl ein ganzzahliges Vielfaches einer zweiten Anzahl k ist;
    b) ein Rahmenprüfsequenz-Modul (FCS), welches dafür konfiguriert ist, die besagte erweiterte Sequenz (ES) zu empfangen und eine erweiterte Prüfsequenz (r(T/k)) der besagten erweiterten Sequenz (ES) unter Verwendung der besagten zweiten Anzahl k als Berechnungsparallelismusgrad zu berechnen, wobei der besagte höchstwertige Teil, welcher die besagten vordefinierten Bits ($A_T$, ..., $A_{m+2}$, $A_{m+1}$) enthält, während einer letzten Evolutionsperiode in das besagte Rahmenprüfsequenz-Modul (FCS) eingegeben wird; und
    c) ein Kompensationsmodul (CM'), welches dafür konfiguriert ist, die besagte erweiterte Prüfsequenz (r(T/k)) zu empfangen und auf die besagte erweiterte Prüfsequenz (r(T/k)) eine Kompensation zum Kompensieren eines Beitrags der besagten vordefinierten Bits ($A_T$, ..., $A_{m+2}$, $A_{m+1}$) anzuwenden, wodurch die besagte Prüfsequenz (CS) erhalten wird, wobei das besagte Kompensationsmodul (CM') mindestens eine Kompensationsschaltung (CC) umfasst, welche dafür konfiguriert ist, den Beitrag einer vordefinierten Anzahl von den besagten vordefinierten Bits ($A_T$, ..., $A_{m+2}$, $A_{m+1}$) zu kompensieren,

    **dadurch gekennzeichnet, dass** das besagte Kompensationsmodul (CM') weiterhin eine Rückkopplungsschleife umfasst, wobei die besagte Kompensationsschaltung (CC) Teil der besagten Rückkopplungsschleife ist, und wobei das besagte Kompensationsmodul (CM') weiterhin einen Ladeblock (LB) umfasst, welcher für das Extrahieren der besagten Prüfsequenz (CS) aus der besagten Rückkopplungsschleife nach einer weiteren vordefinierten Anzahl von Evolutionsperioden der besagten Rückkopplungsschleife konfiguriert ist.

2.  Vorrichtung (CD) nach Anspruch 1, wobei die besagte Kompensationsschaltung (CC) eine Matrix umfasst, welche auf die Inverse einer in dem besagten Rahmenprüfsequenz-Modul (FCS) enthaltenen Matrix (M2) bezogen ist.

3.  Vorrichtung (CD) zur Berechnung einer Prüfsequenz (CS) einer in einem paketvermittelten Netzwerk zu übertragenden Datensequenz (DS), wobei die Vorrichtung (CD) umfasst:

    a) ein Modul zur Erzeugung einer erweiterten Sequenz (ESG), welches dafür konfiguriert ist, die besagte Datensequenz (DS) zu empfangen und eine erweiterte Sequenz (ES) mit einer ersten Anzahl von Bits zu erzeugen, wobei die besagte erweiterte Sequenz (ES) die besagte Datensequenz (DS) in einem niedrigstwertigen Teil davon umfasst, und wobei die besagte erweiterte Sequenz (ES) vordefinierte Bits ($A_T$, ..., $A_{m+2}$, $A_{m+1}$) in einem restlichen höchstwertigen Teil davon umfasst, wobei die besagte erste Anzahl ein ganzzahliges Vielfaches einer zweiten Anzahl k ist;
    b) ein Rahmenprüfsequenz-Modul (FCS), welches dafür konfiguriert ist, die besagte erweiterte Sequenz (ES) zu empfangen und eine erweiterte Prüfsequenz (r(T/k)) der besagten erweiterten Sequenz (ES) unter Verwendung der besagten zweiten Anzahl k als Berechnungsparallelismusgrad zu berechnen, wobei der besagte höchstwertige Teil, welcher die besagten vordefinierten Bits ($A_T$, ..., $A_{m+2}$, $A_{m+1}$) enthält, während einer letzten Evolutionsperiode in das besagte Rahmenprüfsequenz-Modul (FCS) eingegeben wird; und
    c) ein Kompensationsmodul (CM), welches dafür konfiguriert ist, die besagte erweiterte Prüfsequenz (r(T/k)) zu empfangen und auf die besagte erweiterte Prüfsequenz (r(T/k)) eine Kompensation zum Kompensieren eines Beitrags der besagten vordefinierten Bits ($A_T$, ..., $A_{m+2}$, $A_{m+1}$) anzuwenden, wodurch die besagte Prüfsequenz (CS) erhalten wird,

    **dadurch gekennzeichnet, dass** das besagte Kompensationsmodul (CM) mindestens eine erste Kompensationsschaltung (CC1) und eine zweite Kompensationsschaltung (CC2) umfasst, wobei die erste Kompensationsschaltung (CC1) dafür konfiguriert ist, den Beitrag einer ersten vordefinierten Anzahl der besagten vordefinierten Bits ($A_T$, ..., $A_{m+2}$, $A_{m+1}$) zu kompensieren, und wobei die zweite Kompensationsschaltung (CC2) dafür konfiguriert ist, den Beitrag einer zweite vordefinierten Anzahl der besagten vordefinierten Bits ($A_T$, ..., $A_{m+2}$, $A_{m+1}$) zu kompensieren, wobei die besagte erste vordefinierte Anzahl gleich acht ist, und die besagte zweite vordefinierte Anzahl gleich sechzehn ist, wobei die besagte zweite Kompensationsschaltung (CC2) seriell an die besagte erste Kompensationsschaltung (CC2) angeschlossen ist.

**4.** Netzwerkelement eines paketvermittelten Netzwerks, wobei das besagte Netzwerkelement eine Vorrichtung (CD) zur Berechnung einer Prüfsequenz (CS) einer in dem besagten paketvermittelten Netzwerk zu übertragenden Datensequenz (DS) umfasst, wobei die besagte Vorrichtung (CD) einem beliebigen der Ansprüche 1 bis 3 entspricht.

**5.** Computerprogramm, umfassend computerausführbare Befehle zum Durchführen, wenn das besagte Computerprogramm auf einem Computer läuft, eines Verfahrens zum Berechnen einer Prüfsequenz (CS) einer in einem paketvermittelten Netzwerk zu übertragenden Datensequenz (DS), wobei das besagte Verfahren umfasst:

a) Empfangen der besagten Datensequenz (DS) und Erzeugen einer erweiterten Sequenz (ES) mit einer ersten Anzahl von Bits, wobei die besagte erweiterte Sequenz (ES) die besagte Datensequenz (DS) in einem niedrigstwertigen Teil davon umfasst, und wobei die besagte erweiterte Sequenz (ES) vordefinierte Bits ($A_T$, ..., $A_{m+2}$, $A_{m+1}$) in einem restlichen höchstwertigen Teil davon umfasst, wobei die besagte erste Anzahl ein ganzzahliges Vielfaches einer zweiten Anzahl k ist;
b) Berechnen einer erweiterten Prüfsequenz ($r(T/k)$) der besagten erweiterten Sequenz (ES) unter Verwendung der besagten zweiten Anzahl k als Berechnungsparallelismusgrad, wobei der besagte höchstwertige Teil, welcher die besagten vordefinierten Bits ($A_T$, ..., $A_{m+2}$, $A_{m+1}$) enthält, während einer letzten Evolutionsperiode eingegeben wird; und
c) Anwenden, auf die besagte erweiterte Prüfsequenz ($r(T/k)$), einer Kompensation zum Kompensieren eines Beitrags der besagten vordefinierten Bits ($A_T$, ..., $A_{m+2}$, $A_{m+1}$), wodurch die besagte Prüfsequenz (CS) erhalten wird,

wobei das besagte Computerprogramm **dadurch gekennzeichnet ist, dass** die besagte Kompensation das Kompensieren des Beitrags einer ersten vordefinierten Anzahl der besagten vordefinierten Bits ($A_T$, ..., $A_{m+2}$, $A_{m+1}$) und das serielle Kompensieren des Beitrags einer zweiten vordefinierten Anzahl der besagten vordefinierten Bits ($A_T$, ..., $A_{m+2}$, $A_{m+1}$) umfasst, wobei die besagte erste vordefinierte Anzahl gleich acht ist, und die besagte zweite vordefinierte Anzahl gleich sechzehn ist.

## Revendications

**1.** Dispositif (CD) pour calculer une séquence de vérification (CS) d'une séquence de données (DS) à transmettre dans un réseau à commutation de paquets, le dispositif (CD) comprenant :

a) un module de génération de séquence étendue (ESG) configuré pour recevoir ladite séquence de données (DS) et pour générer une séquence étendue (ES) possédant un premier nombre de bits, ladite séquence étendue (ES) comprenant ladite séquence de données (DS) dans une partie la moins importante de celle-ci, et ladite séquence étendue (ES) comprenant des bits prédéfinis ($A_T$, ..., $A_{m+2}$, $A_{m+1}$) dans une partie restante la plus importante de celle-ci, ledit premier nombre étant un multiple entier d'un deuxième nombre k ;
b) un module de séquence de vérification de trame (FCS) configuré pour recevoir ladite séquence étendue (ES) et pour calculer une séquence de vérification étendue ($r(T/k)$) de ladite séquence étendue (ES) en utilisant ledit deuxième nombre k comme degré de parallélisme de calcul, dans lequel ladite partie la plus importante comprenant des bits prédéfinis ($A_T$, ..., $A_{m+2}$, $A_{m+1}$) est ajoutée dans ledit module de séquence de vérification de trame (FCS) au cours d'une dernière période d'évolution ; et
c) un module de compensation (CM') configuré pour recevoir ladite séquence de vérification étendue ($r(T/k)$) et pour appliquer à ladite séquence de vérification étendue ($r(T/k)$) une compensation pour compenser une contribution desdits bits prédéfinis ($A_T$, ..., $A_{m+2}$, $A_{m+1}$), obtenant ainsi ladite séquence de vérification (CS), ledit module de compensation (CM') comprenant au moins un circuit de compensation (CC) configuré pour compenser la contribution d'un nombre prédéfini desdits bits prédéfinis ($A_T$, ..., $A_{m+2}$, $A_{m+1}$),

**caractérisé en ce que** ledit module de compensation (CM') comprend en outre une boucle de rétroaction, ledit circuit de compensation (CC) faisant partie de ladite boucle de rétroaction, et ledit module de compensation (CM') comprenant en outre un bloc de charge (LB) configuré pour extraire ladite séquence de vérification (CS) de ladite boucle de rétroaction après un autre nombre prédéfini de périodes d'évolution de ladite boucle de rétroaction.

**2.** Dispositif (CD) selon la revendication 1, dans lequel ledit circuit de compensation (CC) comprend une matrice associée à l'inverse d'une matrice (M2) comprise dans ledit module de séquence de vérification de trame (FCS).

**3.** Dispositif (CD) pour calculer une séquence de vérification (CS) d'une séquence de données (DS) à transmettre dans un réseau à commutation de paquets, le dispositif (CD) comprenant :

a) un module de génération de séquence étendue (ESG) configuré pour recevoir ladite séquence de données (DS) et pour générer une séquence étendue (ES) possédant un premier nombre de bits, ladite séquence étendue (ES) comprenant ladite séquence de données (DS) dans une partie la moins importante de celle-ci, et ladite séquence étendue (ES) comprenant des bits prédéfinis ($A_T$, ..., $A_{m+2}$, $A_{m+1}$) dans une partie restante la plus importante de celle-ci, ledit premier nombre étant un multiple entier d'un deuxième nombre k ;

b) un module de séquence de vérification de trame (FCS) configuré pour recevoir ladite séquence étendue (ES) et pour calculer une séquence de vérification étendue (r(T/k)) de ladite séquence étendue (ES) en utilisant ledit deuxième nombre k comme degré de parallélisme de calcul, dans lequel ladite partie la plus importante comprenant lesdits bits prédéfinis ($A_T$, ..., $A_{m+2}$, $A_{m+1}$) est ajoutée dans ledit module de séquence de vérification de trame (FCS) au cours d'une dernière période d'évolution ; et

c) un module de compensation (CM) configuré pour recevoir ladite séquence de vérification étendue (r(T/k)) et pour appliquer à ladite séquence de vérification étendue (r(T/k)) une compensation pour compenser une contribution desdits bits prédéfinis ($A_T$, ..., $A_{m+2}$, $A_{m+1}$), obtenant ainsi ladite séquence de vérification (CS), **caractérisé en ce que** ledit module de compensation (CM) comprend au moins un premier circuit de compensation (CC1) et un deuxième circuit de compensation (CC2), le premier circuit de compensation (CC1) étant configuré pour compenser la contribution d'un premier nombre prédéfini desdits bits prédéfinis ($A_T$, ..., $A_{m+2}$, $A_{m+1}$) et le deuxième circuit de compensation (CC2) étant configuré pour compenser la contribution d'un deuxième nombre prédéfini desdits bits prédéfinis ($A_T$, ..., $A_{m+2}$, $A_{m+1}$), ledit premier nombre prédéfini étant égal à huit et ledit deuxième nombre prédéfini étant égal à seize, ledit deuxième circuit de compensation (CC2) étant connecté en série audit premier circuit de compensation (CC1).

**4.** Elément de réseau d'un réseau à commutation de paquets, ledit élément de réseau comprenant un dispositif (CD) pour calculer une séquence de vérification (CS) d'une séquence de données (DS) à transmettre dans ledit réseau à commutation de paquets, ledit dispositif (CD) existant selon l'une des revendications 1 à 3.

**5.** Programme informatique comprenant des instructions exécutables par ordinateur pour exécuter, lorsque ledit programme informatique est exécuté sur un ordinateur, un procédé de calcul d'une séquence de vérification (CS) d'une séquence de données (DS) à transmettre dans un réseau à commutation de paquets, ledit procédé comprenant :

a) réception de ladite séquence de données et génération d'une séquence étendue (ES) possédant un premier nombre de bits, ladite séquence étendue (ES) comprenant ladite séquence de données (DS) dans une partie la moins importante de celle-ci, et ladite séquence étendue (ES) comprenant des bits prédéfinis ($A_T$, ..., $A_{m+2}$, $A_{m+1}$) dans une partie restante la plus importante de celle-ci, ledit premier nombre étant un multiple entier d'un deuxième nombre k ;

b) calcul d'une séquence de vérification étendue (r(T/k)) de ladite séquence étendue (ES) en utilisant ledit deuxième nombre k comme degré de parallélisme de calcul, dans lequel ladite partie la plus importante comprenant lesdits bits prédéfinis ($A_T$, ..., $A_{m+2}$, $A_{m+1}$) est ajoutée pendant une dernière période d'évolution ; et

c) application à ladite séquence de vérification étendue (r(T/k)) d'une compensation pour compenser une contribution desdits bits prédéfinis ($A_T$, ..., $A_{m+2}$, $A_{m+1}$), obtenant ainsi ladite séquence de vérification (CS),

ledit programme informatique étant **caractérisé en ce que** ladite compensation comprend la compensation de la contribution d'un premier nombre prédéfini desdits bits prédéfinis ($A_T$, ..., $A_{m+2}$, $A_{m+1}$) et la compensation en série de la contribution d'un deuxième nombre prédéfini desdits bits prédéfinis ($A_T$, ..., $A_{m+2}$, $A_{m+1}$), ledit premier nombre prédéfini étant égal à huit et ledit deuxième nombre prédéfini étant égal à seize.

Figure 1

| $A_m$ | .... | $A_{k(i+1)}$ | .... | $A_{(ki)+2}$ | $A_{(ki)+1}$ | .... | $A_k$ | .... | $A_2$ | $A_1$ |

↙↝ DS

## Figure 2a

EP 1 981 171 B1

I(T/k)                                        I(i)                                    I(1)

| $A_T$ | .... | $A_{m+2}$ | $A_{m+1}$ | $A_m$ | .... | $A_{k(i+1)}$ | .... | $A_{(ki)+2}$ | $A_{(ki)+1}$ | .... | $A_k$ | .... | $A_2$ | $A_1$ |

↙↝ ES

DS

## Figure 2b

Figure 3

Figure 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030120992 A
- US 6519737 B